(19) Europäisches Patentamt
European Patent Office
Office européen des brevets

(11) **EP 4 418 484 A1**

(12) **EUROPEAN PATENT APPLICATION**

(43) Date of publication:
**21.08.2024 Bulletin 2024/34**

(51) International Patent Classification (IPC):
***H02J 3/32*** (2006.01)   ***H02J 7/00*** (2006.01)

(21) Application number: **23156471.7**

(22) Date of filing: **14.02.2023**

(52) Cooperative Patent Classification (CPC):
**H02J 3/32; H02J 7/00712; H02J 7/007182;**
G01R 31/388; G01R 31/392; H02J 7/0048;
H02J 7/005; H02J 2207/50

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Hitachi Energy Ltd**
**8050 Zürich (CH)**

(72) Inventors:
• **Patzelt, Nikolaus**
**8004 Zürich (CH)**
• **Larsson, Mats**
**5102 Rupperswil (CH)**
• **Zhang, Hongyang**
**11524 Stockholm (SE)**
• **Heydari, Rasool**
**72212 Västerås (SE)**

(74) Representative: **AWA Sweden AB**
**Box 45086**
**104 30 Stockholm (SE)**

(54) **ENERGY STORAGE MANAGEMENT SYSTEM**

(57) There is disclosed herein a method for managing an energy storage system, ESS, having one or more supercapacitors, the method comprising obtaining a desired power transfer between the ESS and a power grid, and determining a reference voltage for providing the desired power transfer between the ESS and the power grid based on a state of health, SoH, of the ESS. There is further disclosed herein a non-transitory computer-readable medium configured to perform such a method, an energy storage management system, ESMS, comprising the non-transitory computer-readable medium, and a power system comprising the ESMS.

Figure 1

EP 4 418 484 A1

## Description

### Technical Field

The present disclosure relates to a method for managing an energy storage system, ESS, an energy storage management system, ESMS, for carrying out the method in an ESS, and a power system comprising an ESS, having such an ESMS comprised therein.

### Background

Energy storage systems (ESSs) are systems for storing electrical energy in bulk. The electrical energy may have been generated by inconsistent generating means and, thus, ESSs conveniently provide a way to store generated electrical energy for later use, as desired, even if the generating means themselves are offline. As such, ESSs may form an important part of a renewable energy distribution grid comprising, for example, solar or wind generation.

ESSs can be integrated with converters to form enhanced power grid systems. An example of such a system is an enhanced static synchronous compensator (E-STATCOM), which integrates a converter system (e.g., full-bridge-based modular multilevel converter (MMC)) with a supercapacitor-based energy storage system (ESS).

The E-STATCOM is capable of supplying active and/or reactive power to a power grid. However, the ESS contains a limited amount of electrical energy, and thus it is conventional for such a system, and in particular an ESMS therein, to track the SoC of the ESS and to operate it accordingly, i.e., to regulate a power transfer between the ESS and the power grid.

There is a desire to provide improved methods for managing an ESS, as such improvements may lead to a slower degeneration of the components of the ESS and thus increase the operational lifetime of the ESS, and accordingly any E-STATCOM system in which the ESS is installed.

### Summary

It is realized as a part of the present disclosure that the power and energy capabilities of the ESS may vary over time due to ageing of the components, such as a reduction in capacitance of the supercapacitors. Hence, aspects of the present disclosure provide methods for managing an ESS that take such changing capabilities into control operations, such as when implementing the ESS in an E-STATCOM system. Aspects of the present disclosure consider the SoC, the SoH, current, power, and/or energy limitations of an ESS, and provide an overall control strategy that advantageously improves the operational lifetime of the ESS.

In particular, according to an aspect of the present disclosure, there is provided a method for managing an ESS, having one or more supercapacitors. The method comprises obtaining a desired power transfer between the ESS and a power grid, and determining a reference voltage (i.e., a reference capacitor voltage) for providing the desired power transfer between the ESS and the power grid based on a state of health, SoH, of the ESS.

The method may then further comprise initiating the desired power transfer between the ESS and the power grid using the determined reference voltage; and controlling, with a controller, the power transfer between the ESS and the power grid based on a desired state of charge, SoC, of the ESS.

According to a further aspect of the present disclosure, the control method is carried out by an energy storage management system, ESMS, having a control unit or the like implemented as, or comprising, a transitory or non-transitory computer readable medium comprising instructions which, when executed by a processor, cause the processor to carry out the control method.

According to yet a further aspect of the present disclosure, there is provided a power system, comprising a converter coupled to a power grid, and an ESS, operatively coupled to the converter and configured to transfer power to and/or from the power grid via the converter. The ESS comprises the above-mentioned ESMS configured to perform the control methods described herein.

It will be understood by those skilled in the art that a STATCOM can inject and absorb power to and from a power grid. For example, if a frequency drop is detected in the power grid, an E-STATCOM may provide power from an ESS to the power grid response, thereby providing frequency support to the power grid.

Aspects of the present disclosure relate primarily to the replenishment of the energy stored within the ESS. That is, during normal operations of an E-STATCOM, the ESS is recharged using power from the power grid. However, it is realized as a part of the present disclosure that excessively high voltage levels during the discharge and recharging of an ESS (containing one or more supercapacitors) may lead to the premature degradation thereof if the SoH of the ESS is not taken into account.

Thus, by obtaining a desired power transfer between the ESS and a power grid, based on a state of charge, SoC, of the ESS (i.e., indicating that the SoC is below or above a set point), and determining a reference voltage for providing the desired power transfer between the ESS and the power grid based on a state of health, SoH, of the ESS, the lifetime of the ESS may be extended.

Put another way, the reference voltage across the ESS, used to provide power to the ESS and thereby change its SoC, can be adapted regularly according to a SoH estimation, with an aim of minimizing the voltage across the ESS and thereby extending its lifetime. The reference voltage may be updated according to the SoH update, i.e., in response thereto, thereby being "automatically" updated with each SoH update.

The SoC of the ESS may be estimated using any suitable estimator, such as the terminal voltage of the ESS, and may be estimated online (i.e., during operation of the ESS) or offline (when the ESS is not operating). However, according to an advantageous refinement of the presently disclosed control method, the SoC is determined online, additionally or alternatively based on an estimated (or measured) voltage across at least one of the one or more supercapacitors.

In some examples wherein the ESS comprises a plurality of supercapacitors, a suitable accuracy for estimating the SoC of the entire ESS may be achieved based on the voltage (and/or inferred SoC) of only one of the supercapacitors, because it may be expected that the SoC of all of the supercapacitors is balanced according to some balancing scheme.

The SoH of the ESS may also be estimated using any suitable estimator. For example, the SoH of the ESS may be determined based on a terminal voltage and/or current of the ESS, depending on the implementation. The SoH of the ESS may be impacted by the temperature and/or voltage which the capacitors of the ESS are subjected to over their lifetime. Temperature fluctuations may be approximated based on, e.g., the current value, or measured directly using a thermometer. It may be assumed, however, that the temperature of a supercapacitor during its lifetime will remain substantially constant, although it will also be appreciated that a non-constant temperature does not substantially affect the resultant control.

Over its lifetime and as its SoH varies, the equivalent capacitance of the ESS also varies. Since the equivalent capacitance of the ESS varies over time due to ageing, the dynamic response of the ESS (i.e., during changes in SoC such as during recharging of the ESS) will vary over time, if the SoC regulator uses controller gains that are fixed. It will be understood that 'controller gains' are those used in a control function such as a proportional-integral (PI) or proportional-integral-derivative (PID) control.

Hence, according to an example refinement of the present disclosure, the control method further comprises determining one or more gain factors, according to which a controller is configured to control the power transfer, based on the SoH of the ESS.

As the gains of the control can be adapted during operation based on the SoH estimate, which takes into account changes in the equivalent capacitance of the ESS, the same dynamic response of the ESS can be maintained over the lifetime thereof, even if the equivalent capacitance varies significantly due to SoH variations. Accordingly, a more intuitive way of tuning the parameters of the SoC control, compared to a direct selection of controller parameters, is provided.

Optionally, the control method(s) according to aspects of the present disclosure can be paused or disabled when the connected grid leaves a defined frequency band. Put another way, according to an optional refinement of the presently disclosed control method, power is not transferred between the ESS and the power grid if is determined that the power grid has a grid frequency outside of a frequency band. The determination that the power grid has a grid frequency outside of a frequency band may be measured directly or indirectly, such as by using an output of a phase-locked loop controlling a converter reference signal, or otherwise.

Advantageously, such an approach reduces the load on the grid when the frequency is not at its nominal value (e.g., 50 Hz). It can be assumed that the grid is vulnerable when the frequency is at a large offset from the nominal frequency. Thus, it might be a possibility that recharging the ESS (i.e., transferring power between the ESS and the power grid) will have a negative effect on the grid. Furthermore, it is possible that the grid will recover from a low or high frequency episode and return to nominal frequency, and the error between a reference voltage and the actual voltage might consequently decrease again. If the ESMS were active in the meantime, there would be a risk of excessive charging (or discharging) of the ESS, upon which the ESMS control must act again. Consequently, the frequency band disabling the ESMS may lead to a reduced power exchange during frequency transients and ensure that power for energy management purposes is only exchanged during a steady state of the grid.

According to aspects of the present disclosure, a customizable reference voltage profile may be represented as:

$$V_{dc}^{ref,sugg} = \left(V_{dc}^{ref,EOL} - V_{dc}^{ref}\right) \cdot a_{margin} + V_{dc}^{ref}.$$

Here, $V_{dc}^{ref}$ is the adaptable reference voltage (a SoH-dependent minimum calculated reference voltage),

$V_{dc}^{ref,EOL}$ is a reference voltage at end-of-life of the ESS and $\left(V_{dc}^{ref,EOL} - V_{dc}^{ref}\right) \cdot a_{margin}$ represents a voltage margin. The voltage margin is optionally introduced as a buffer on top of a minimum voltage for reliable operation in a power grid application. Adding the margin thus advantageously provides an additional degree of freedom as $\alpha_{margin}$ can be selected depending on the particular implementation of the power system. The margin represents an intelligent trade-off between improved lifetime and an increased safety, in terms of available energy in the ESS, and can be selected for different applications depending on, for example, a desired level of reliability, an expected range of loads on the ESS, etc.

Put another way, the control method according to presently disclosed aspects may include an option step of determining a voltage margin based on an estimated reference voltage at an end of life of the ESS and/or a current SoH of the ESS (i.e., the most recently determined SoH for the ESS), and determining the reference voltage further based on the determined voltage margin. The voltage margin may be determined based at least in part on a minimum required reference voltage of the ESS at the end of life of the ESS.

In conventional power systems, most grid forming control scheme designs assume that there is a large energy storage, for example batteries, with a time constant much longer than the electromechanical dynamics related to inertial response required of the ESS. As such, the SoC of the battery can be considered effectively constant when designing the control system.

However, in an E-STATCOM that employs supercapacitors, for example, a much smaller energy storage is typically used, and the SoC dynamics are not well separated in time from the inertia emulation dynamics required of the ESS - often in the order of seconds. Therefore, it is advantageous to consider the SoC of the ESS when calculating the active and reactive power capability of the ESS, to reduce the risk of overcharging or undercharging the ESS. As used here, the active and reactive power capability of the ESS is the amount of active or reactive power that the ESS is considered as being able to provide at any instant of time, e.g., from the perspective of the controller, i.e., an advertised availability of active or reactive power.

For this purpose, a dynamic active and reactive power capability strategy can be incorporated into the control method according to aspects of the present disclosure. Such a strategy implements an advantageously accurate and fast enforcement of active and reactive power limits provided by the underlying grid forming control scheme.

In particular, according to an optional refinement of the presently disclosed control techniques, the method further comprises dynamically varying a threshold power capability of the ESS, corresponding to a threshold amount of power capable of being transferred between the ESS and the power grid, based the SoC of one or more supercapacitors comprised in the ESS. As mentioned above, the threshold power capability comprises a minimum or maximum active and/or reactive power capable of being transferred between the ESS and the power grid, or at least the values thereof that can be provided to a controller when devising an overall control strategy for the ESS. The power transfer between the ESS and the power grid may then be limited based on the threshold power capability.

The threshold power capability may be varied further based on a total energy storage capacity of the ESS and/or a parameter indicative of the converter capacity, such as one or more of SoC, DC voltage, AC side current, DC side current, modulation index, and the like.

According to such an approach, the SoC and/or energy storage current can be maintained between minimum and maximum values, and the converter AC side output current magnitude can be maintained below a maximum value. Moreover, the converter can be configured to operate in active power priority mode, such that the remaining current margin is made available for reactive power compensation.

It will be appreciated that various elements of the presently disclosed control method may be performed individually or in any combination, depending on the particular implementation, while still achieving the associated advantageous effects.

## Brief Description of the Drawings

The above and other aspects of the present disclosure will now be described in more detail, with reference to the appended figures, wherein:

Figure 1 schematically shows a power system, according to aspects of the present disclosure; and
Figure 2 schematically shows an example embodiment of an energy storage management system.

## Detailed Description

The present disclosure is described in the following by way of a number of illustrative examples. It will be appreciated that these examples are provided for illustration and explanation only and are not intended to be limiting on the scope of the disclosure.

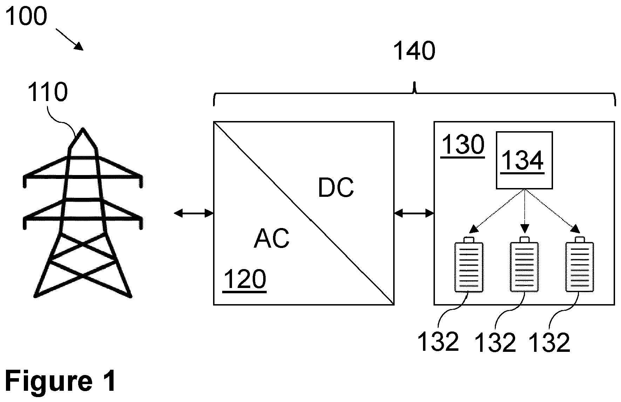

Figure 1 schematically shows a power system 100, according to aspects of the present disclosure. The power system 100 comprises a converter 120 coupled to an energy storage system (ESS) 130 so as to form an energy storage enhanced converter system 140. The converter 130 is coupled to a power grid 110 and configured to transfer power between the power grid 110 and the ESS 130, the details of which configuration are beyond the scope of the present disclosure, and well understood by those skilled in the art.

According to the illustrated example, the power grid 110 is an alternating current (AC) power grid. The converter 120 is thus configured to convert direct current (DC) from the ESS 130 to AC for distribution on the power grid 110, and configured to convert AC from the power grid 110 to DC for providing power to the ESS 130. In alternative examples, the power grid 110 may be a high-voltage DC (HVDC) power grid, in which examples the converter 120 may be a DC-DC converter.

The converter 120 may be a static synchronous compensator (STATCOM), and therefore the energy storage enhanced converter system 140 may be an energy storage enhanced STATCOM system, also referred to as an E-STATCOM system.

The ESS 130 as illustrated in figure 1 comprises a plurality of supercapacitors 132 serving as energy storage units. In alternative examples, only one energy storage unit may be implemented in the ESS 130 and/or the energy storage unit(s) may be battery cells, fuel cells, or regular capacitors, depending on the implementation.

The operations and state of the ESS 130 are monitored and controlled (such operations being generalized as the ESS being 'managed') by an energy storage management system (ESMS) 134. The ESMS may be implemented as hardware and/or software and, although the ESMS is shown as being part of the ESS 130, it will be appreciated that, in some examples, the ESMS may be implemented as a separate unit from the ESS 130 that may be remote from the supercapacitors 132.

Among other things, the ESMS may monitor a state of charge (SoC) of the supercapacitors 132, a terminal voltage for each supercapacitor 132 and/or the ESS 130 as a whole, and/or a current flow through the ESS 130 (e.g., including through each individual supercapacitor 132). The ESS 130 may be configured with sensors to measure information relevant to such monitoring and control. Such sensors may communicate with a controller comprised in the ESMS 134 and configured to implement management processes. It will be appreciated that such a controller may be implemented as a transitory or non-transitory computer-readable medium comprising instructions which, when executed by a processor, cause the processor to carry out such management processes.

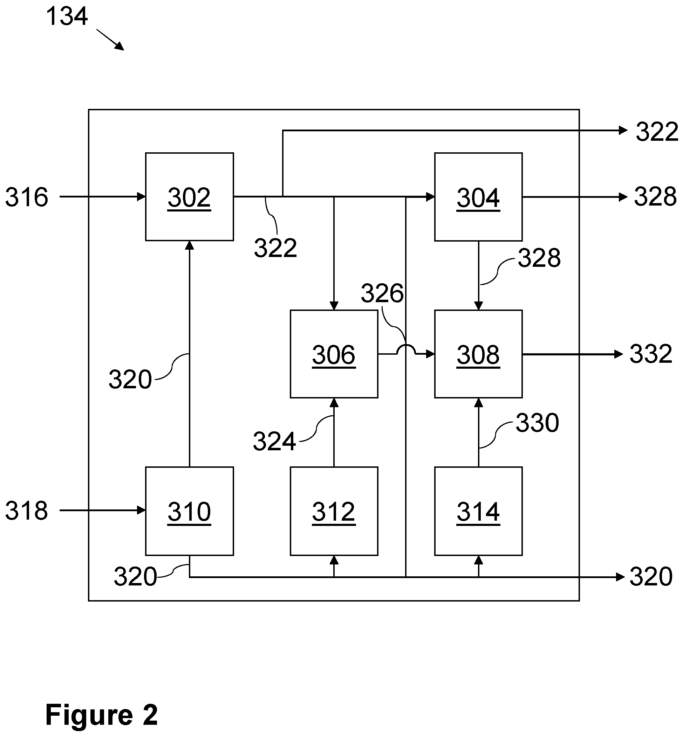

Figure 2 schematically shows an example embodiment of an ESMS 134 such as that discussed above in relation to figure 1. As shown in this figure, the ESMS 134 may be considered as comprising a plurality of subsystems or modules.

In the illustrated example of figure 3, the ESMS 134 comprises a SoC estimating module 302 configured to estimate the SoC of the ESS and a SoH estimating module 310 configured to estimate the SoH of the ESS.

The energy stored in a capacitor is proportional to its capacitance and the square of the voltage therefrom. Thus, the SoC estimating module receives, as input, a terminal voltage of the ESS and/or a voltage across one or more capacitors 316, as well as an estimated equivalent capacitance of the supercapacitor(s) of the ESS 320 from the SoH estimating module 310. The SoC estimating module 302 then provides, as output, an estimated SoC of the ESS. This output of an estimated SoC of the ESS 322 is then provided as a useable output from the ESMS 134 so as to inform other processes in the power system, for example. The output of the estimated SoC of the ESS 322 is further provided to other internal modules of the ESMS 134.

The ESMS 134 further comprises a dynamic power capability calculating module 304 which receives, as input, the estimated SoC of the ESS 322 and provides, as output, dynamic active and reactive power limitations for the ESS 328.

The ESMS 134 further comprises an error reference calculating module 306 configured to determine a difference between a reference amount of energy stored in the ESS (i.e., a setpoint for SoC) and the actual amount of energy stored (or SoC) in the ESS. The error reference calculating module 306 receives, as input, the estimated SoC of the ESS 322 and outputs an error reference signal 326.

The error reference signal 326 is provided to a controller 308 which is configured to control the power transfer between the ESS and the power grid - i.e., charging and discharging of the ESS. The output of the controller 308 is thus a power reference signal 332.

The gains used by the controller (e.g., as part of a PI or PID control scheme or similar) are adjusted based on the SoH of the ESS. That is, the estimated SoH represented as an equivalent capacitance 320 is provided to a control parameter determining module 314, which determines control parameters (i.e., the gains) for use by the controller 308 based on the estimated SoH 320 of the ESS and provides these to the controller 308.

The controller 308 is further provided with the dynamic power capability of the ESS 328 calculated by the dynamic power capability calculating module 304 so as to further base the control of power transfer between the ESS and the power grid on the power capability of the ESS.

The ESMS 134 further comprises a voltage reference calculating module 312 configured to determine a reference voltage 324 for providing a desired power transfer between the ESS and the power grid based on the estimated SoH of the ESS 320 provided by the SoH estimating module 310. The reference voltage 324 is provided to the error reference calculating module 306 such that the desired power transfer can be controlled by the controller 308 according to the error reference 326.

It will be appreciated that the above described modules and their interconnection is entirely schematic and provided as an example to understand a possible implementation of control methods as described herein. That is, individual modules may be implemented in isolation, or in any other combination, with or without further possible modules, depending on the intended implementation.

While the present disclosure is susceptible to various modifications and alternative forms, specific examples are shown and described in relation to the drawings, with a view to clearly explaining the various advantageous aspects of the present disclosure. It should be understood, however, that the detailed description herein and the drawings attached hereto are not intended to limit the disclosure to the particular form disclosed. Rather, the intention is to cover all modifications, equivalents, and alternatives falling within the scope of the following claims, including the possible combination of various elements of these specific examples.

**Claims**

1. A method for managing an energy storage system, ESS, having one or more supercapacitors, the method comprising:

    obtaining a desired power transfer between the ESS and a power grid; and
    determining a reference voltage for providing the desired power transfer between the ESS and the power grid based on a state of health, SoH, of the ESS.

2. The method according to claim 1, further comprising:

    determining the desired power transfer between the ESS and the power grid based on the state of charge, SoC, of the ESS; and
    controlling, with a controller, the power transfer between the ESS and the power grid using the determined reference voltage.

3. The method according to claim 2, further comprising:
   determining one or more gain factors, according to which the controller is configured to control the power transfer, based on the SoH of the ESS.

4. The method according to any claim 2 or claim 3, further comprising:
   determining the SoC online during operation of the ESS, based on an estimated voltage across at least one of the one or more supercapacitors.

5. The method according to any preceding claim, further comprising:
   determining the SoH of the ESS based on a terminal voltage and/or current of the ESS.

6. The method according to any preceding claim, wherein:
   power is not transferred between the ESS and the power grid if is determined that the power grid has a grid frequency outside of a frequency band.

7. The method according to any preceding claim, further comprising:

    determining a voltage margin based on an estimated reference voltage at an end of life of the ESS; and
    determining the reference voltage further based on the determined voltage margin.

8. The method according to claim 7, wherein:
   the voltage margin is determined based at least in part on a minimum required reference voltage of the ESS at a current SoH and/or the end of life of the ESS.

9. The method according to any preceding claim, further comprising:
   dynamically varying a threshold power capability of the ESS, corresponding to a threshold amount of power capable of being transferred between the ESS and the power grid, based on the SoC of one or more supercapacitors comprised in the ESS.

**10.** The method according to claim 9, wherein:
the threshold power capability comprises a minimum or maximum active and/or reactive power capable of being transferred between the ESS and the power grid.

**11.** The method according to claim 9 or claim 10, wherein:
the threshold power capability is varied further based on a total energy storage capacity of the ESS.

**12.** The method according to any of claims 9 to 11, further comprising:
limiting a power transfer between the ESS and the power grid based on the threshold power capability.

**13.** A non-transitory computer-readable medium comprising instructions which, when executed by a processor, cause the processor to carry out the method according to any preceding claim.

**14.** An energy storage management system, ESMS, comprising the non-transitory computer-readable medium according to claim 13.

**15.** A power system, comprising:

a converter coupled to a power grid; and
an energy storage system, ESS, operatively coupled to the converter and configured to transfer power to and/or from the power grid via the converter, wherein the ESS comprises the ESMS according to claim 14.

**Figure 1**

134

316 → 302

318 → 310

302 → 322
320
322 → 304 → 328
328
306 326
324
308 → 332
330
312 314
320 → 320

**Figure 2**

Europäisches
Patentamt
European
Patent Office
Office européen
des brevets

# EUROPEAN SEARCH REPORT

Application Number

EP 23 15 6471

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CN 115 603 337 A (XIAN THERMAL POWER RES INST CO ET AL.) 13 January 2023 (2023-01-13) | 1,2,4,5, 9-12 | INV. H02J3/32 H02J7/00 |
| A | * figure 1 * * claim 1 * * paragraph [0102] – paragraph [0105] * ----- | 3,6-8 | |
| Y | CN 108 631 348 A (SOUTHERN POWER GRID PEAKING FREQUENCY MODULATION POWER GENERATION CO L) 9 October 2018 (2018-10-09) | 1,2,4,5, 9-12 | |
| A | * figure 1 * * claim 1 * * paragraph [0008] – paragraph [0012] * * paragraph [0058] – paragraph [0075] * ----- | 3,6-8 | |
| A | CN 103 457 281 B (STATE GRID CORP CHINA; CHINA ELECTRIC POWER RES INST ET AL.) 20 April 2016 (2016-04-20) * the whole document * ----- | 1-15 | |

TECHNICAL FIELDS
SEARCHED      (IPC)

H02J

The present search report has been drawn up for all claims

| Place of search | Date of completion of the search | Examiner |
|---|---|---|
| Munich | 18 August 2023 | Martin, Raynald |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

......................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 15 6471

This annex lists the patent family members relating to the patent documents cited in the above-mentioned European search report.
The members are as contained in the European Patent Office EDP file on
The European Patent Office is in no way liable for these particulars which are merely given for the purpose of information.

18-08-2023

| Patent document cited in search report | | Publication date | Patent family member(s) | Publication date |
|---|---|---|---|---|
| CN 115603337 | A | 13-01-2023 | NONE | |
| CN 108631348 | A | 09-10-2018 | NONE | |
| CN 103457281 | B | 20-04-2016 | NONE | |

EPO FORM P0459

For more details about this annex : see Official Journal of the European Patent Office, No. 12/82